# EUROPEAN PATENT SPECIFICATION

(11) **EP 0 423 150 B1**
(45) Date of publication and mention of the grant of the patent: **04.11.1998**
(21) Application number: 89906339.0
(22) Date of filing: 05.05.1989
(51) Int. Cl.: G03F 7/20, G03F 7/12, B41C 1/14

(54) **A SCANNER SYSTEM FOR SUCCESSIVE IRRADIATION OF A WORKING SURFACE, PARTICULARLY FOR ULTRA-VIOLET EXPOSURE OF A PHOTO EMULSION ON A SERIGRAPHIC PRINTING FRAME**
SCANNERSYSTEM FÜR DIE SUKZESSIVE BESTRAHLUNG EINER ARBEITSOBERFLÄCHE, INSBESONDERE FÜR DIE ULTRAVIOLETTBESTRAHLUNG EINER PHOTOEMULSION AUF EINEM SERIGRAPHISCHEN DRUCKRAHMEN
SYSTEME DE BALAYAGE SERVANT A L'EXPOSITION SUCCESSIVE D'UNE SURFACE A TRAVAILLER ET EN PARTICULIER A L'EXPOSITION AUX ULTRAVIOLETS D'UNE PHOTOEMULSION SUR UN CADRE D'IMPRESSION SERIGRAPHIQUE

(30) Priority: 05.05.1988 DK 243888; 08.12.1988 DK 683488
(43) Date of publication of application: 24.04.1991
(73) Proprietor: MOGRAFO A/S, DK-7190 Billund (DK)
(72) Inventor: Andersen, Allan, Vincent, DK-8660 Skanderborg (DK)
(74) Representative: Wittrup, Flemming
(86) International application number: DK8900108
(87) International publication number: WO8911116

(56) References cited:
- DE-A- 2 725 307

## Description

The present invention relates to a method of preparing graphical printing elements of the serigraphical printing frame type with a view to the production of a printing surface, which in accordance with a model pattern is formed with areas which are permeable and non-permeable respectively to dye.

In this field it is common practice to lay out a photographic emulsion on the permeable fabric layer of a serigraphic printing frame and to cover said emulsion with a photographic film indicating the desired print picture in full size, after which the assembly is irradiated with powerful ultra violet light for exposing the emulsion on the fabric layer through a contact print of the film picture, so that afterwards it is possible to treat the emulsion in such a manner that it becomes selectively permeable to dye in accordance with the desired pattern.

However, this is a troublesome and expensive process, a.o. because it may be expensive to produce the required films in the relatively very large sizes which may occur, e.g. with edge dimensions essentially exceeding 1 metre both lengthwise and crosswise.

DE-A-27 25 307 discloses a method of preparing graphical printing elements and a scanning device for the execution of the method, wherein the scanning unit scans the entire width of the printing elements.

The invention is based on the acknowledgment that it is possible to affect the photographic emulsion in a more direct manner, i.e. by irradiating it with a concentrated light beam, which is controlled so as to describe the desired print picture on the print surface. Typically a laser beam may be applied which from a transmission head is caused to sweep over the surface of the emulsion by a scanning process which by an associated computer control produces just the desired printing pattern, without the latter having to be present in full size.

It has been found, however, that such a scanning cannot easily cover a lane area with a width of more than 50-60 cm, which is far too little in the performance of many relevant tasks of printing, for which reason it has been necessary to operate with said contact prints in case of broader subjects. The width limitation in question is due to certain basic limitations of a modulated scanning; in connection with the invention it has not been found possible to alter said limitations.

EP 0 264 886 A2 discloses a method of preparing graphical printing elements and a scanning device for the execution of the method, wherein the scanning unit scans the entire width of the printing elements.

A similar system is disclosed in DE A 27 25 307.

On this background the invention proposes to carry out the preparation of an extended emulsion coated print surface by successively irradiating said area from a beam head in parallel, adjoining lanes of limited width, provision being made to control the operation in such a manner that the individual lane portions are coherent as to the motif.

In order to obtain a reasonably good result, i.e. without essential visible distortions of the print pattern in the border line areas between the various scanning lanes, it is not sufficient to carry out an accurate mechanical guiding of a scanner head with relation to the print element, as more problems in connection with the scanning process are associated with the production of such an accurate side bounding of the scanning lane, that this lane can fulfil the requirement of accurate merging with the adjacent lane or lanes. In case of a single lane edge, displacements of the order of 1 mm will normally be insignificant, whereas such displacement will be quite unacceptable in case of for example a vertical border line inside a print pattern surface, where the aim should be to keep possible displacement below 0.1 mm, as otherwise visually noticeable border lines may be formed even in coarse print patterns, though it may be difficult to concretely show the presence of such border lines.

Therefore the present invention also deals thoroughly with the scanner itself, as an improved version thereof is almost a condition of making the invention broadly applicable, which, of course is the result aimed at. Therefore this important aspect of the invention will be discussed in detail below.

The invention will be explained in more detail in the following with reference to the drawings, in which
Fig. 1 is a schematic, perspective view illustrating the principal invention.
Fig. 2 is a perspective view of a system for execution of a scanning in accordance with the invention,
Fig. 3 is a perspective detail view of a scanner unit used in said system,
Fig. 4 is a detail view of the output end of the scanner opposite the working surface,
Fig. 5 is a detail view for further explanation of Fig. 4,
Fig. 6 are graphical curves illustrating movements of an oscillating mirror used in the system, and
Fig. 7 is a graphical picture of the light spot path on the working surface.

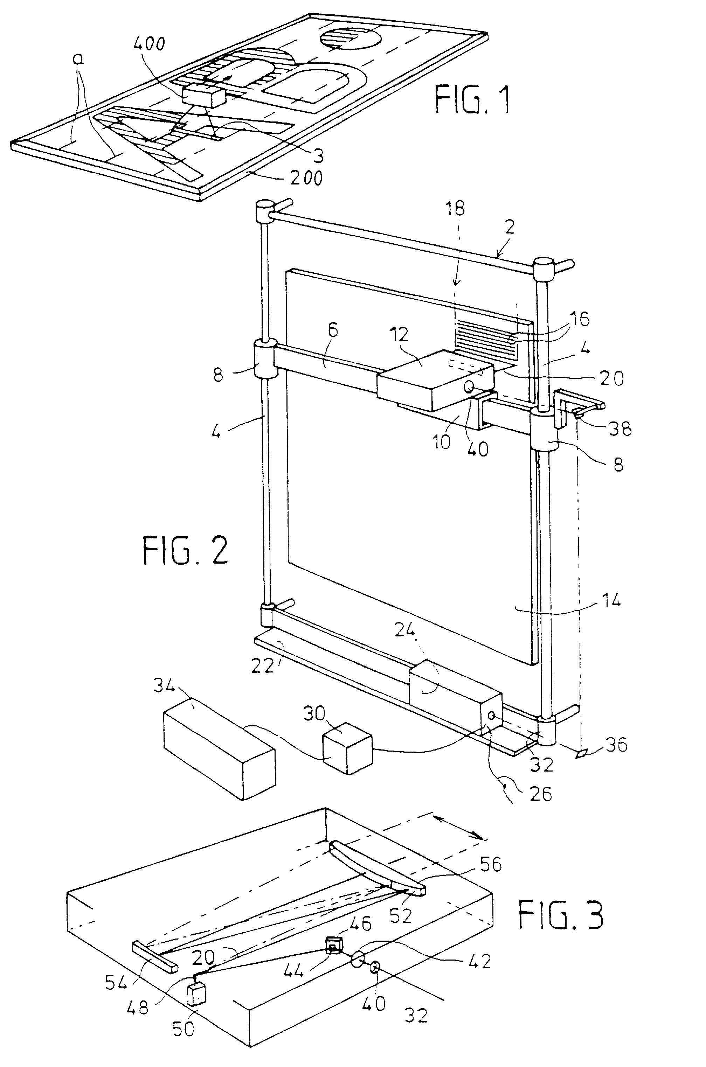

Fig. 1 illustrates schematically a serigraphical frame 200 placed below a laser scanner 400, which sweeps across the print surface of the frame along a transverse line 3 which is considerably shorter than the width of the print surface. The print surface is coated with a photographic emulsion which is meant to be irradiated for the production of the print pattern indicated by outlines; of course said pattern may assume any other form.

The scanner 400 is so mounted with relation to the frame as to be displaceable both lengthwise and transversely across the print surface of the frame, but controlled to move very accurately parallel therewith, so that the length of the scanner line 3 will be the same everywhere at the occuring angular oscillation of the laser beam from the scanner.

The ideal situation would be one, in which the scanner can be moved a single time across the middle of the frame and all the way produce the line 3 with a length that is sufficient to cover the whole width of the printing surface, whereby the desired printing pattern can be produced by a suitable computer controlled modulation of the light beam. Only it appears in practice that the obtainable length of line is so limited that it cannot be extended to the entire width of only fairly large printing surfaces.

In the light of this the invention provides for controlling the scanner to move in such a manner, relatively, that it can work the printing surface along parallel partial zones or lanes shown in the drawing separated by stippled lines a. With a suitable programming of the control computer it can be obtained that the scanner is moved successively along the respective zones to irradiate these zones for producing the partial pictures of the print motif associated with said zones. Hereby it is insignificant whether the absolute length of the line 3 is somewhat larger than the width of the zones, if only it is secured that the laser beam is extinguished in the areas where it is potentially directed towards adjacent zone areas which should not be irradiated in the cycle of operation in question.

Referring to Fig. 2 it is shown how a system for the execution of the method may be arranged. The system comprises a wall mounted frame 2 with vertical guide members 4, between which is mounted a vertically displaceable cross rail 6 provided with sliding sleeves 8 which embrace the guide members 4, means not shown being provided for causing a downward movement of the cross member 6, 8 along the guide members 4 with a smooth, relatively low speed and an upward movement with substantially higher speed.

A horizontally displaceable carrier 10 for a scanning device 12 is mounted on the cross rail 6. The carrier 10 is in a manner not shown provided with a motor part for controlled movement of said part and hence the scanner 12 along the cross rail 6. A working subject 14 in the form of a serigraphic frame with a photo emulsion coating to be treated by irradiation from the scanner 12 may be placed on the wall surface within the frame 2, it being shown that the scanner 12 can work said surface by irradiating it in horizontal lines 16 downwards along a vertical lane field 18, as a light beam 20 oscillating backwards and forwards is supplied from the scanner 12 during the moving down of the scanner on the cross rail 6. The speed of moving down is so adjusted that the lines 16 of irradiation will be drawn edge to edge as seen in relation to the oscillating frequency of the beam 20.

On a lower, fixed support 22 on the frame 2, a UV-laser 24 is mounted which is provided with a power supply line 26 and has a modulator connected through a line to a control unit 30 for switching the laser beam designated 32 on and off, the control unit being connected to a computer 34, in which the desired print pattern can be recovered. Further in a manner not shown the computer 34 or the control unit is connected to the means for moving the carrier 10 of the scanner and for vertically moving the cross rail 6.

The laser beam 32 hits a fixed deflecting mirror 36, which directs the beam vertically upwards along the right side of the frame 2, where it hits a second mirror 38 placed on the right sliding sleeve 8, from which it is transmitted to the scanner 12 through an opening 40 in the side thereof. Within the scanner the beam passes various lens and mirror systems as described below with the result that it finally appears an oscillating beam directed towards the subject 14. It will be understood that by means of a very accurate construction of the mechanical system it is secured that the laser beam all the time is introduced into the scanner on the same place and with the same direction, no matter how the scanner is moved vertically and horizontally.

In a system as described above it would in principle be possible to use a scanner 12 of a previously known construction, but in most cases for the result would be highly useless for two reasons, i.e. partly because the prior art scanners operate either far too slow to be practically usable for the present application, or much too inaccurate to produce sharply linearly limited working zones, which can be joined to adjacent zones without clearly visible transitions.

Therefore, according to the invention it has been considered necessary to make use of a further developed scanner; the problems presenting themselves in connection therewith shall be explained in more detail in the following:-

In the scanning process several essential problems occur when an ultra violet laser beam is used and when print patterns of high quality, i.e. high degree of resolution of the pattern, are desired. The production of ultra violet light is rather costly wherefore reduction of the losses to the least possible should be aimed at, and the demand for a high degree of resolution involves the need of working with a rather accurate focusing of the laser beam on the print element. This demand is difficult to meet in the desirable extremes, as certain basic problems in relation to an accurate focusing occur as a consequence of 1) that the laser beam is subjected to changes of direction between a point of deflection and a line segment sweeped by the beam on the receiving surface, whereby the length of the beam and hence the focal point will change all the time as seen from the planar receiving surface, 2) that the focal point of the beam may be outside a larger or smaller part of the receiving surface, unless this is placed at a very accurate prescribed distance from the scanner, 3) that during their runs back and forth the scanner lines will overlap each other in the reversing areas making it difficult to produce unambiguous print patterns in these areas, 4) that the same overlap gives rise to a noticeable power problem, because double power is dissipated in said overlap areas, and 5) that the prior art scanners are rather slow in operation.

An associated further purpose of the invention is to provide measures for extensive remedy of these adverse conditions, i.e. to provide a scanner, which is able to operate fast and with an accurate focusing while maintaining an almost maximum and extremely well defined working width. Generally, for various reasons it is difficult to operate with an accurate scanning, when the effective working width exceeds about 40 cm; though the invention involves aspects that might contribute to improvement also of this condition, this is not to be further discussed here.

Light scanning is most frequently performed by using a rotating polygon mirror hit by a light or laser beam, which beforehand has passed a focusing lens and by the successive passings of the rotating mirror facets is caused to sweep across the surface to be treated. The surface is moved relatively to the scanner in the transverse direction of the lines, which the scanner hereby "draws" on the surface, whereby a larger area can be treated successively. When the beam is modulated, while the light spot is running through the individual lines, i.e. is switched on and off or intensity controlled from an associated control unit, the desired pattern of treatment can be produced with more or less accuracy according to the quality of the scanner.

The beam length between the focusing lens and the working surface will be shortest for the beam which in the center position of the mirror facets impinges on the surface at right angles, whereas the length increases towards both sides. If the focusing is sharp in the center area, it may in case of a fairly large working width be difficult or impossible to obtain sharp focusing in the outer areas, unless the working surface is curved on a cylinder face with the axis going through the focusing lens. However, this problem, also mentioned under 1) above, has already been solved in principle, i.e. by the application of a correcting optics, which is passed by the oscillating beam and varies its focal length, i.e. the distance to the focal point, according to the swing angle, just so that the focal point can be held on a planar surface fairly uniformly all over the line.

In return the working surface must then be positioned at the distance in question from the lens or from the device as such. A certain slight variation of the distance may be tolerated, which also is needed in practice, but this immediately entails another problem, i.e. that a slight increase in the distance will mean that the increase in length of the outermost swung out beams in the angle position in question will be larger than the increase in length of the center beam. This has two adverse effects, i.e. partly that the possible range of variation of the position of the working surface is limited by the fact that it must be within the depth definition of the outer beams, and partly that a change of position of the working surface will means not only a relatively larger change of length of the outer beams, but also a corresponding change of the effective length of the working line on the surface; when the distance is increased, the outer beams will reach farther out on the surface, and if during the movement of the scanner relative to the surface the distance variations in question occur, the result will be that the working width will vary so that straight lines, which in the outer areas of the working lane extend in the longitudinal direction thereof, will be correspondingly distorted or wavy.

This presents a problem in itself, but particularly so when entire working lanes shall be caused to join each other very accurately, as in case of the technique which is the primary aspect of the invention. A genuinely accurate print will require a practically unrealistic accurate set-up of the working surface relatively to the scanner and to the applied moving means.

According to the invention the beam is caused to pass an optical system at a short distance outside the working surface, preferably a lens bar which is adapted to deflect the beam everywhere in such a manner that all over the length of the working line it impinges perpendicularly on the working surface. Thus the lens will be a convex lens with its focal point positioned in the area such as said polygonal mirror, from which the beam is oscillated.

Thus, this lens must extend throughout the working line, i.e. it is a fairly large optical element, but apart from the length dimension the element may be of a rather moderate size, as it is to operate exclusively with a beam which is oscillated in a fixed plane relatively to the scanner, i.e. the lens bar may have a thickness of e.g. only a few millimetres.

When the beam all the time is delivered perpendicularly onto the working surface, a possible slight deviation of the distance of the working surface from the scanner as seen along the said working lane will not cause any distortion of the print pattern; in case of such a deviation the outer beams will not hit the working surface correspondingly farther out or in, and the length of the working line will remain constant. In addition an improvement with relation to the other problem is obtained in that the length of the outer beams are not shortened, as they are now sent from the lens directly, not obliquely towards the surface. Though this shortening is not very large, it still means that the depth definition range can be utilized better when not limited by a slanting of the outer beams.

Thus the result is that hereafter it will be possible to perform the work extremely accurately, e.g. with degrees of resolution of less than 1/10 mm, without the need of overwhelming accuracies with respect to the positioning of the working surface; the distance of this surface from the scanner may vary several millimetres or even a few centimetres.

The demand for the high degree of resolution involves another aspect, viz. that very thin focusing beams must be used, e.g. with a thickness of 25 microns, and as the working lines should be closely adjoining in order to ensure full continuity of the print, the speed of operation understood as the speed of displacement along said working lane will be determined by the velocity with which the working lines can be terminated successively for yielding their respective contribution of e.g. 25 microns to the displacement. It goes without saying that the working lines must be produced with a quite high frequency in order to enable operation with a fairly realistic velocity. Obviously quite high line frequencies can be obtained by application of a rotating polygonal mirror, though centrifugal forces set certain limits to the speed of rotation, but in the use of rotating mirror facets considerable losses occur, which are unacceptable when, as in the present invention, ultra violet light is primarily applied which is expensive to produce. The explanation of these losses is that at each passage of a corner between two mirror facets past the incident laser beam having a certain thickness, which considerably exceeds the 25 microns mentioned by way of example, a splitting up of the beam between the two facets takes place, and while this is going on, neither of the beam parts will be usable for effective operation, i.e. the beam should be switched off in this transitional phase, which according to the circumstances may occupy a considerable percentage of the operating time. Thereby the switching off will not bring about any essential saving, as the laser device in itself has to operate with full power in the meantime.

As an alternative to the rotating polygonal mirror it is known to use an oscillating goniometer mirror, which is in permanent contact with the incident beam and can be vibrated in a controlled manner to produce a back and forth swing of the light beam without the occurrence of said ineffective operating phases.

Within certain limitations these single mirrors can be controlled to perform a backward and forward turning with constant angular velocity, whereby there will be a linear relation between the turning and the travel of the light spot along the working line, so that there is no unlinear function to be paid regard to in the programming of the print pattern. However, it is significant to the speed of operation of such mirrors that a short ineffective period must necessarily occur each time the mirror is turned to an extreme position and thereafter is to be turned back. Even this condition sets a noticeable limit to the speed of operation, and it must be realized that the line frequency obtainable in this manner is much too low to permit operation with a practically acceptable velocity.

It is already known that the oscillating frequency of goniometer mirrors can be increased quite essentially by the application of a resonance system, whereby the mirror oscillates with a sinusoidal characteristic. Mirror oscillations with such a high frequency would be desirable in connection with the invention, but then the problem arises that due to the non-constant angular velocity of the sine function a non-linear speed of movement of the light spot on the working surface will occur, and it appears to be difficult to program a computer to take this non-linear relation into account, though this would be a possibility according to the invention. The invention provides a quite different possibility, i.e. the application of an optical correction, the swinging beam from the oscillating mirror being passed via at least one fixed mirror, the mirror face of which is so shaped that the beam reflected therefrom will swing with a uniform angular velocity, when the incident beam oscillates with an angular velocity according to a sine curve, whereby the desired alteration of the characteristic of the movement will be obtained.

Another and more essential problem in the application of a beam oscillating with a non-uniform angular velocity is the fact that the light spot will be moved with uneven velocity along the working line, the velocity in connection with a sinusoidal oscillation being maximum at the center of the line and quite low at the outermost end or turning areas. If the relative movement between the scanner and the working surface takes place with a uniform velocity in order that the successive working lines shall adjoin each other edge to edge over a fairly broad center area, then the lower travelling velocity of the light spot at the outer areas will cause an overexposure in these areas. This can be remedied in that the outer areas are made ineffective by switching off the beam, but as mentioned above such switching off will imply a appreciable loss of efficiency, if it extends over a considerable time, as the laser device is operating continuously. Thus the uniform speed of movement and an only slight lateral overtravel are a primary condition of avoidance of such losses.

However, by using oscillating mirrors, which in some way produces a light spot travel with uniform velocity along the working line, a still larger problem may occur, viz. a possible overlapping of the paths of movement of the light spot in connection with each turning of the light spot movement some distance before and some distance after the turning, as these paths having a certain width are entirely coincident in the very turning points. If or when the paths, i.e. the working lines, are to adjoin each other edge to edge at the center of the field, viz. by displacing the scanner relative to the working surface with a velocity of one line width per half oscillation of the beam, these overlap areas will extend nearly throughout the length of the working lines, varying between full overlapping at the ends and no overlapping exactly at the center of the field. This presents almost impossible control conditions, wherefore it may be more appropriate to prefer the solution allowing the working lines to be completely parallel with each other by the application of a rotating polygonal mirror.

To solve this problem it will be in any case a theoretical possibility to make provision for holding the oscillating mirror still for a very short period in each of its outer positions and for utilizing this short period to advance the scanner/working surface a distance just corresponding to a line width, whereas that advance is suspended during each line passage of the light spot. However, for several reasons this will presumably be totally unrealistic; hence this solution will not be further discussed.

However, the present invention provides an extremely simple solution of the problem in question, viz. the provision of such a control of the light beam in a plane perpendicular to its plane of oscillation that the light spot at the termination of each swing is displaced one line width transversely of the working line, while the beam and hence the light spot during the tracing of the subsequent working line is corrected in the transverse direction to a position edge to edge relatively to the preceding working line. With the simplest kind of control this will be reflected in the working lines being perpendicular to the direction of displacement between the scanner and the working surface, that is irrespective of the fact that this displacement is maintained with uniform velocity during the entire process; an overexposure will occur only in the turning points, where the light spot stays at the transition from the end point of the working line to the short transverse movement to the start point of the succeeding working line. For a perfect operation the beam should be switched off just in this transition area, but in view of the fact that the extension thereof is of the order of 20-30 microns unlike an essential part of the total length of the working line, this necessary switching off will not mean any considerable loss of energy or any significant narrowing of the effective working width.

The transverse displacement in question of the beam or light spot is of such a small size that it can be produced by means of an almost microscopically small movement of a mirror in the beam path, and in a preferred embodiment a mirror mounted on a piezoelectric crystal in front of the goniometer mirror, i.e. at a fairly long distance from the working surface, is used for this deflection. It will be understood that a microscopic movement will suffice here, when the beam spot is to be swung 20-30 microns from a distance of maybe half a metre. The same transverse displacement mirror can by suitable control of said crystal be caused to bring about such corrections of the beam direction which might be desirable to correct irregularities in the remainder of the optical system with a view to bringing about a working line which is rectilinear in an almost absolute sense.

Summarizing the transverse control of the oscillating beam makes it practically possible to utilize a back and forth swinging deflecting mirror with negligible losses, and by means of the optical transformation of a sinusoidally oscillating light or laser beam to a working beam, which is parallel displaced with a uniform velocity all along the working line, several advantageous effects are obtained, viz. partly a very high capacity of work by the application of a resonance oscillating deflecting mirror, partly a very high efficiency of the system, because an operative switching off of the beam may be limited to extremely short time intervals, partly an accurate focusing of the beam all over the length of the working line, and partly a well defined and exactly linear merging of the side edges of the individual working lanes, when these are set up edge to edge for forming broad working faces.

Within the scanner, Fig. 3, the laser beam 32 passes first a focusing lens 42 and thereafter hits a mirror 44, which is firmly mounted on a piezoelectric crystal in a housing 46, from which the beam is directed towards a vibrating mirror 48 connected to a goniometer. This mirror oscillates laterally as a resonance oscillating goniometer mirror thereby transmitting the now oscillating beam designated 20. This beam is directed towards a primary mirror 52, from which the beam is reflected to a secondary mirror 54 and thereupon reflected forwardly through a bar lens 56 for incidence on the print frame 14.

The focal length of the focusing lens 42 is so adapted that the beam 20 will be maximum focused, e.g. down to a width of 25 microns, at the incidence on the print frame 14.

Thus, during a vertical movement of the scanner 12 the lane field 18 on the print frame will be exposed by the back and forth swinging beam 20 which by means of the control unit 30 will be switched on and off for the production of desired differentiated pattern details. After the exposure of the lane field 18 the scanner 12 is moved to an adjacent position on the cross rail 6, so that thereafter another lane field 18 adjoining the previous one can be exposed. In this way the entire print frame can be exposed by use of the required number of horizontal shiftings of the scanner 12, hereby it only is very important that the respective side edge areas of the lane fields are exactly coincident.

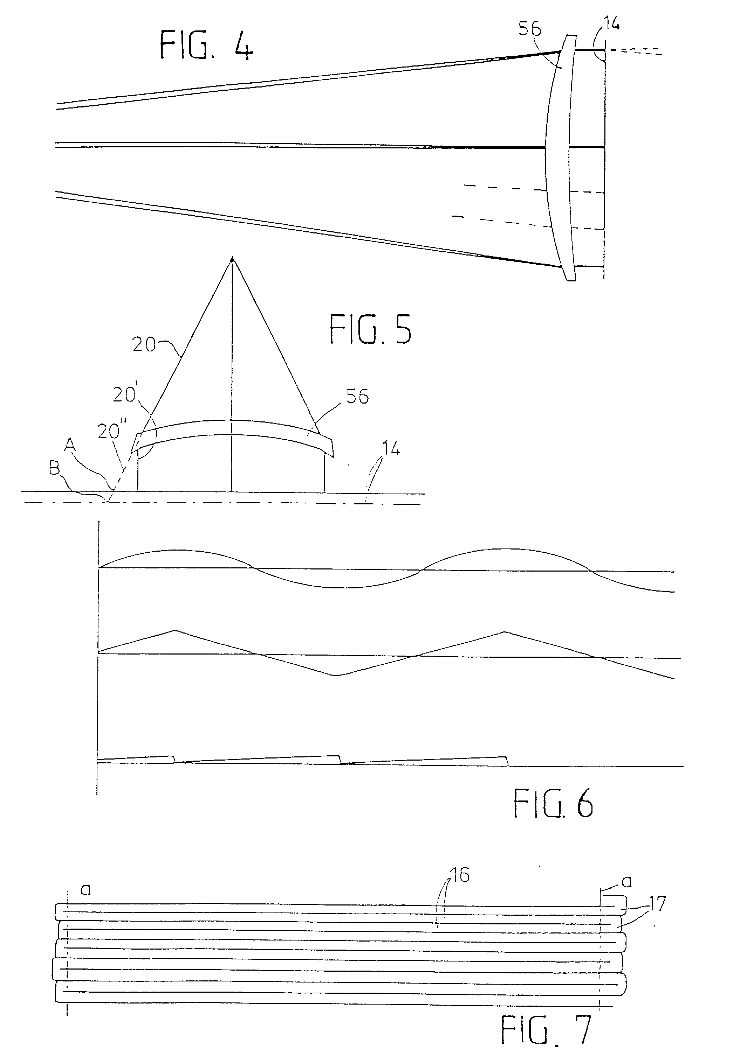

As previously mentioned a first problem hereby is that the working surface or print frame 14 hardly can be placed at an entirely accurate and uniform distance from the scanner, so that problems with respect to varying length of lines 16 may arise. This problem is met by the application of the bar lens 56, this lens as shown in Fig. 4 being so arranged that at every place it deflects the oscillating beam 20 in such a manner that said beam everywhere is directed perpendicularly onto the working surface, whereby the length of line will be independent of, whether the working surface is spaced more or less from the scanner.

Fig. 5 shows in more detail that the beam 20 will pass perpendicularly on to the working surface also at the outer ends as indicated by 20', and it will furthermore be seen that the point of incidence of the beam 20' on the working surface 14 will be the same whether this surface is spaced a little more or less from the scanner. The outer oblique beam 20 would in the absence of the bar lens 56 continue as shown by 20" with a point of incidence A on the surface 14; if the surface is withdrawn to the position shown in a stippled line, this point would obviously be displaced outwardly to the point B, whereby the previously mentioned drawbacks would arise. Furthermore it will be seen that the beam 20" is slightly longer than the beam 20', so that by the use of the lens 56 a more uniform focusing on the working surface all along the working line is obtained.

The goniometer mirror 48 performs rapid resonance oscillations, i.e. with an angular velocity varying in accordance with a sine curve as shown at the top of Fig. 6. The frequency of oscillation may be very high, e.g. 2-3 kHz, which is conditional of a usable capacity of the whole device, e.g. with a treatment time of about 5 minutes for a surface area of 1 m². The sinusoidal oscillation is reflected only in a non-uniform velocity of movement of the light spot along the working line. However, the secondary mirror 54 is made with such a shape that it purely optically corrects for said non-uniformity, so that the oscillating beam leaves the mirror with a uniform angular velocity. The same correction could be made at the primary mirror, but due to its narrower range of operation this mirror would be more difficult to form with exactly the required shape, which, of course, would be still more pronounced as regards the goniometer mirror. The correcting shape has not been further illustrated, but will be defined by the established conditions.

The center curve in Fig. 6 represents the uniform and also rectilinear displacement of the picture point along the working line, i.e. the sine curve after the performed optical correction. The maxima and minima of the curve designate the opposite ends of the working line, at which points the curve has a locally rounded shape, as the turning of swinging direction of the beam cannot be carried out absolutely momentaneously. Thus distortions of the print may occur in the very narrow turning areas in question, but in a preferred embodiment these areas are eliminated from the working field by causing the control unit 24 to switch off the beam in said areas, which gives rise to a negligible loss only.

As mentioned above there is another condition which might give rise to much higher losses or make the use of the resonance oscillating mirror 48 completely impossible, viz. the fact that at each turning the beam will produce a new working line, which will overlap the previous line largely. The invention proposes to remedy this by controlling the piezoelectric crystal in the housing 46 to produce during the formation of each whole working line a slight progressive deflection of the beam 20 in a direction perpendicular to the swinging plane of the beam, i.e. in the direction of the axis of oscillation of the goniometer mirror 48 with a rapid return to the start position at each turning of the beam. The associated pivotal movement of the mirror 44 is shown by the lowermost curve in Fig. 6. When the scanner is operating with a downward movement, each working line 16 will from the beginning get to slope slightly downwards, but said control of the crystal to produce a slight upward deflection of the beam results in the lines 16 being drawn exactly horizontally, the total displacement in a vertical upward direction amounting to just a line width, i.e. the diameter of the focused ultraviolet beam. The quite abrupt return of the mirror to its start position will cause an almost entirely vertical and very nearly momentaneous swinging down of the beam, which is thereby displaced a line width downwardly, and during the immediately succeeding return swing of the beam the light spot will draw a new horizontal working line which in an ideal manner will be placed edge to edge with the preceding line entirely without overlapping or spacing between the lines, i.e. with a line drawing as ideal as in the use of a rotating polygonal mirror.

The drawing of lines described here is illustrated in Fig. 7 in which said vertical and or turning movements of the lines 16 are designated 17. It is indicated that very small irregularities may occur in the swings of the beam 20, but particularly by using a resonance oscillating mirror it is possible to keep the irregularities so small as to be of no practical significance, even if a high degree of accuracy of the edge limitations of the working lanes 18 is required, when these lanes are to be joined as parts of one and the same print surface. Furthermore it has been shown in stippled lines a that these lines between them delimit an irradiated face of considerable width, on which a completely regular pattern of parallel, edge to edge adjoining lines 16 occurs; so it is sufficient to keep the beam switched off in quite narrow areas outside said lines a, which incidentally, of course, will follow the small irregularities of the position of the line ends. These very small, permanent switching off areas are conditional of working with very low losses, this being one of the very important advantages of the invention relatively to the use of polygonal mirrors.

There will hardly be anything to prevent the production of a mirror goniometer, the mirror of which is able to swing in both one plane and the other for integrating the functions of the mirrors 48 and 44, just as the vertical deflection of the beam could be brought about elsewhere in the system, but just the application of a crystal controlled mirror must be assumed to be the simplest arrangement for the attainment of the desired result. Incidentally it should be remarked that an extremely exact production or fine working up of the optical elements is required to obtain an exactly rectilinear course of the working lines 16; just the use of the crystal controlled mirror 44 makes it possible to electrically introduce corrections of adverse bulges on the lines, which can be much easier than to correct the error in question in the optical system.

It should be noted that it may be desirable to guide the scanner unit along laser beams in order that a perfect result shall be obtained.

## Claims

1. A method of preparing a graphical printing element of the serigraphical printing frame type, said element having a printing surface in accordance with a desired model pattern, comprising
directing a sweeping light beam (20) from a scanning unit (12) towards the photographical emulsion on the printing element, said sweeping light beam (20) irradiating the printing element in a light spot which moves forwards and backwards along lines (16) when the element is moved relatively to the scanning unit (12);
modulating the light beam (20) in accordance with said desired model pattern;
and, after exposure, treating the printing surface for development and fixation of the printing pattern,
characterized by
moving the scanning unit (12) along the lanes that consist of a plurality of parallel adjoining lanes of the printing element;
switching off the sweeping light beam (20) when the light spot is outside the side limitation (a; 18) of the lanes; and
ensuring that the respective side limitations (a; 18) of the lanes are exactly coincident, whereby the printing pattern is reproduced correctly according to the desired model pattern, with areas which are permeable and non-permeable, respectively, to dye.

2. A method according to claim 1, characterized in that said scanning along the individual lanes is performed successively by means of one and the same scanning unit (12), which is displaced longitudinally and transversely relatively to the graphical printing element.

3. A scanning device for exposing light on a graphical printing element of the serigraphical printing frame type coated with a photographic emulsion, to provide a printing surface in accordance with a desired model pattern; said device comprising:
at least one scanning unit (12) which directs a sweeping light beam (20) towards the printing element, said sweeping light beam (20) irradiating the printing element in a light spot along lines across lanes when the element is moved relatively to the scanning unit (12);
a control unit (30) for modulating the light beam (20) in accordance with said desired model pattern;
characterized in
that said at least one scanning unit (12) is moved along the lanes which are parallel and adjoining lanes of the printing element;
that said control unit (30) switches off the sweeping light beam (20) when the light spot is outside the side limitation (a; 18) of the lanes; and
that an associated control equipment (30, 34) ensures that the respective side limitations of the lanes are exactly coincident, whereby the printing pattern is reproduced correctly according to the desired model pattern, with areas which are permeable and non-permeable, respectively, to dye.

4. A scanning device according to claim 3, characterized in that at a short distance from the working surface the scanning unit (12) is provided with a lens bar (56), which is placed in the plane of movement of the sweeping light beam (20), and which has the form of a convex lens, with its focal point located in a rotating or oscillating mirror (48) located in the focal point of the lens bar (56), said lens bar directs the beam (20) towards the working surface perpendicularly thereto all along the length of the working line (16).

5. A scanning device according to claim 4, characterized in that the width of the lens bar (56) corresponds to at least twice the width of the working line (16), and that the scanning unit (12) as oscillating mirror (48) comprises a deflecting mirror of a forth and back swinging type and further comprises a controlled optical element (44, 46), preferably a mirror element, for displacing the beam (20) by a line width transversely of the plane of oscillation during each half period of the oscillation and for displacing the beam (20) correspondingly, but abruptly and with an opposite sign at each end of the successive working lines (16).

6. A scanning device according to claim 4, characterized in that the oscillating mirror (48) is of the goniometer controlled resonance swinging type, and that the optical system comprises means for producing from a beam deflection according to a sine function a final beam travel along each working line with constant velocity.

7. A scanning device according to claim 5, characterized in that the optical element (44, 46) is a mirror (44) mounted on a piezoelectric crystal (46).

8. A scanning device according to claim 7, characterized in that a control unit associated with the crystal (46) is adapted to be programmed to correct the orthogonal deflection in the optical system.

## Patentansprüche

1. Verfahren zur Vorbereitung eines graphischen Druckelementes des Typs des serigraphischen Druckrahmens, wobei dieses Element eine Druckoberfläche in Übereinstimmung mit einem gewünschten Modellmuster aufweist, mit den Schritten
- Ausrichten eines abtastenden Lichtstrahls (20) von einer Abtasteinheit (12) auf die photographische Emulsion auf dem Drukkelement hin, wobei der abtastende Lichtstrahl (20) das Druckelement an einem Lichtpunkt beleuchtet, der sich vorwärts und rückwärts entlang von Linien (16) bewegt, wenn das Element relativ zu der Abtasteinheit (12) bewegt wird,
- Modulieren des Lichtstrahls (20) in Übereinstimmung mit dem gewinschten Modellmuster, und
Behandeln der Druckoberfläche nach der Belichtung zur Entwicklung und Fixierung des Druckmusters,
**dadurch gekennzeichnet,**
- dass die Abtasteinheit (12) entlang den Bahnen bewegt wird, die aus einer Vielzahl von parallelen und benachbarten Bahnen des Druckelementes bestehen,
- dass der abtastende Lichtstrahl (20) ausgeschaltet wird, wenn der Lichtpunkt ausserhalb der Seitenbegrenzung (a; 18) der Bahnen ist, und
- dass gewährleistet wird, dass die jeweiligen Seitenbegrenzungen (a; 18) der Bahnen exakt koinzident sind, wodurch das Druckmuster in richtiger Weise entsprechend dem gewünschten Modellmuster reproduziert wird, welches Bereiche aufweist, die für Farbstoff durchlässig oder undurchlässig sind.

2. Verfahren nach Anspruch 1, dadurch gekennzeichnet, dass das besagte Abtasten entlang den einzelnen Bahnen nacheinander durch ein und dieselbe Abtasteinheit (12) durchgeführt wird, die longitudinal und transversal relativ zu dem graphischen Druckelement bewegt wird.

3. Scannervorrichtung, um Licht auf ein graphisches Druckelement des Typs des serigraphischen Druckrahmens zu leiten, das mit einer photographischen Emulsion beschichtet ist, um eine Druckoberfläche in Übereinstimmung mit einem gewünschten Modellmuster zu erzeugen, wobei diese Vorrichtung umfasst:
- mindestens eine Ablenkeinheit (12), die einen abtastenden Lichtstrahl (20) auf ein Druckelement leitet, wobei der besagte abtastende Lichtstahl (20) das Druckelement an einem Lichtpunkt entlang von Linien über Bahnen Beleuchtet, wenn das Element relativ zur Abtasteinheit (12) bewegt wird, und
- eine Steuereinheit (30) zum Modulieren des Lichtstrahls (20) in Übereinstimmung mit dem gewünschten Modellmuster,
**dadurch gekennzeichnet,**
- dass die zumindest eine Abtasteinheit (12) entlang den Bahnen bewegt wird, die parallel und benachbarte Bahnen des Druckelementes sind,
- dass die gesagte Steuereinheit (30) den abtastenden Lichtstrahl (20) ausschaltet, wenn der Lichtpunkt ausserhalb der Seitenbegrenzung (a; 18) der Bahnen ist, und
- dass eine zugeordnete Steuereinrichtung (30, 34) gewährleistet, dass die jeweiligen Seitenbegrenzungen der Bahnen exakt koinzident sind, wodurch das Druckmuster in richtiger Weise entsprechend der gewünschten Modellmuster reproduziert wird, welches Bereiche aufweist, die für Farbstoff durchlässig oder undurchlässig sind.

4. Scannervorrichtung nach Anspruch 3, dadurch gekennzeichnet, dass in einer kurzen Abstand von der Arbeitsoberfläche die Abtasteinheit (12) mit einer Stablinse (56) versehen ist, die in der Bewegungsebene des abtastenden Lichtstrahls (20) angeordnet ist und die die Gestalt einer konvexen Linse aufweist, wobei deren Brennpunkt in einem rotierenden oder oszillierenden Spiegel (48) angeordnet ist, der in dem Brennpunkt der Stablinse (20) angeordnet ist, und dass diese Stablinse den Strahl (20) auf die Arbeitsoberfläche rechtwinklig zu dieser entlang der Länge der Arbeitslinie (16) wirft.

5. Scannervorrichtung nach Anspruch 4, dadurch gekennzeichnet, dass die Breite der Linse (56) zumindest dem Doppelten der Breite den Arbeitslinie (16) entspricht, und dass die Abtasteinheit (12) als oszillierender Spiegel (48) einen umlenkenden Spiegel des hin- und herschwingenden Typs und weiterhin ein gesteuertes optisches Element (44, 46), vorzugsweise ein Spiegelelement, Umfasst, um den Strahl (20) um eine Linienbreite transversal zur Oszillationsebene während jeder Halbperiode der Oszillation zu verschieben und um den Strahl (20) entsprechend aber abrupt und mit einem entgegengesetzten Vorzeichen an jedem Ende der aufeinanderfolgenden Arbeitslinien (16) zu verschieben.

6. Scannervorrichtung nach Anspruch 4, dadurch gekennzeichnet, dass der oszillierende Spiegel (48) vom Typ eines Goniometer gesteuerten Resonanzschwingtyps ist, und dass das optische System Mittel umfasst, um aus einer Strahlablenkung gemäss einer Sinusfunktion einen endgültigen Strahlenweg entlang jeder Arbeitslinie mit konstanter Geschwindigkeit herzustellen.

7. Scannervorrichtung nach Anspruch 5, dadurch gekennzeichnet, dass das optische Element (44, 46) ein Spiegel (44) ist, der auf einem piezoelektrischen Kristall (46) montiert ist.

8. Scannervorrichtung nach Anspruch 7, dadurch gekennzeichnet, dass eine Steuereinheit, die dem Kristall (46) zugeordnet ist, eingerichtet ist, um programmiert zu werden, um die orthogonale Ablenkung in dem optischen System zu korrigieren.

## Revendications

1. Procédé pour préparer un élément graphique d'impression du type d'un cadre d'impression sérigraphique, où l'élément possède une surface d'impression qui est en accord avec un modèle souhaité, comprenant
- diriger un faisceau lumineux balayant (20) d'une unité de balayage (12) envers une photoémulsion sur l'élément d'impression, où le faisceau lumineux balayant (20) expose l'élément d'impression à un point lumineux qui se propage en avant et en arrière le long de lignes (16) quand l'élément est déplacé relativement par rapport à l'unité de balayage (12),
- moduler le faisceau lumineux (20) suivant le modèle souhaité, et
- traiter la surface d'impression après l'exposition pour le développement et la fixation du modèle d'impression,
caractérisé par
- déplacer l'unité de balayage (12) le long de bandes qui consistent en une pluralité de bandes parallèles et avoisinantes de l'élément d'impression,
- couper le faisceau lumineux balayant (20) quand le point lumineux est à l'extérieur de la limitation de page (a; 18) des bandes, et
- assurer que les limitations de page (a; 18) respectives sont exactement coïncidentes, pour que le modèle d'impression soit reproduit correctement suivant le modèle souhaité, comportant des zones qui sont perméables ou non-perméables à un colorant.

2. Procédé selon la revendication 1, caractérisé en ce que le balayage le long des bandes individuelles est obtenu successivement par le moyen d'une seule unité de balayage (12) qui est déplacée longitudinalement et transversalement relatif par rapport à élément graphique d'impression.

3. Système de balayage pour exposer de la lumière sur un élément graphique d'impression d'un cadre d'impression sérigraphique qui est couvert avec une photoémulsion pour proposer une surface d'impression qui est en accord avec un modèle souhaité, avec
- au moins une unité de balayage (12) qui dirige un faisceau lumineux balayant (20) envers un élément d'impression, où le faisceau lumineux balayant (20) expose élément d'impression à un point lumineux qui se propage le long de lignes sur des bandes quand l'élément est déplacé relativement par rapport à l'unité de balayage (12),
- un moyen de contrôle (30) pour moduler le faisceau lumineux (20) suivant le modèle souhaité,
caractérisé en ce que
- cette unité de balayage (12), au moins une, est déplacée le long de bandes qui sont parallèles et avoisinantes de l'élément d'impression,
- le moyen de contrôle (30) coupe le faisceau lumineux balayant (20) quand le point lumineux est à l'extérieur de la limitation de page (a; 18) des bandes, et en ce que
- un équipement associé de contrôle (30, 43) assure que les limitations de page des bandes sont exactement coïncidentes, pour que le modèle d'impression soit reproduit correctement suivant le modèle souhaité, comportant des zones qui sont perméables ou non-perméables à un colorant.

4. Système de balayage selon la revendication 3, caractérisé en ce que une barre de lentille (56) est prévue dans une distance courte de la surface de travail de l'unité de balayage (12), quelle lentille est placée dans la surface de déplacement du faisceau lumineux balayant (20) et quelle lentille a la forme d'une lentille convexe avec son point focal localisé dans un miroir rotatif ou oscillant (48) qui est prévu dans le point focal de la lentille (56), et en ce que cette lentille dirige le faisceau (20) envers la surface de travail perpendiculairement à elle tout le long de la ligne de travail (16).

5. Système de balayage selon la revendication 4, caractérisé en ce que la largeur de la barre de lentille (56) correspond à au moins le double de la largeur de la ligne de travail (16) et en ce que l'unité de balayage (12) en tant que miroir oscillant (48) comporte un miroir de déflexion du type oscillatoire et comporte en plus un élément optique commandé (44, 46), préférablement un élément de miroir, pour déplacer le faisceau (20) d'une largeur de ligne transversalement par rapport au plan d'oscillation dans chaque demi-période de l'oscillation et pour déplacer le faisceau (20) de la même manière, mais abruptement et avec un signe opposé a chaque fin des lignes de travail (16) successives.

6. Système de balayage selon la revendication 4, caractérisé en ce que le miroir oscillant (48) est du type oscillant par résonance contrôlé goniometriquement et en ce que le système optique comporte des moyens pour produire a partir d'une déflexion un faisceau suivant une fonction sinusoïdale un chemin final du faisceau le long de chaque ligne de travail avec une vitesse constante.

7. Système de balayage selon la revendication 5, caractérisé en ce que l'élément optique (44, 46) est un miroir (44) qui est monté sur un cristal piézo-électrique (46).

8. Système de balayage selon la revendication 7, caractérisé en ce que l'unité de contrôle associé au cristal (46) est adapté à être programmé pour corriger la déflexion orthogonale dans le système optique.
